(19) Europäisches Patentamt
European Patent Office
Office européen des brevets

(11) **EP 2 448 029 A2**

(12) **EUROPEAN PATENT APPLICATION**

(43) Date of publication:
**02.05.2012 Bulletin 2012/18**

(51) Int Cl.:
***H01L 39/24*** *(2006.01)*

(21) Application number: **11180126.2**

(22) Date of filing: **06.09.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.10.2010 JP 2010242379**

(71) Applicant: **Hitachi Cable, Ltd.**
**Chiyoda-ku**
**Tokyo (JP)**

(72) Inventors:
• **Ohata, Katsumi**
**Tokyo (JP)**
• **Kimura, Morio**
**Tokyo (JP)**
• **Nakagawa, Kazuhiko**
**Tokyo (JP)**
• **Miyashita, Katsumi**
**Tokyo (JP)**

(74) Representative: **Betten & Resch**
**Patentanwälte**
**Theatinerstrasse 8**
**80333 München (DE)**

(54) **Precursor for Nb3Sn superconductor wire, superconductor wire using the same and method for manufacturing Nb3Sn superconductor wire**

(57) A precursor for a $Nb_3Sn$ superconductor wire is configured to be manufactured by the internal Sn diffusion method. The precursor includes a Cu tube including a barrier layer at an inner surface thereof. The barrier layer includes a metal selected from the group consisting of Ta, Ta-alloy, Nb and Nb-alloy. A plurality of Sn single cores are disposed in the Cu tube. Each of the Sn single cores includes Sn or Sn-alloy. A plurality of Nb single cores are also disposed in the Cu tube. Each of the Nb single cores includes Nb or Nb-alloy. The Sn single cores and the Nb single cores are arranged in the Cu tube such that the Sn single cores are not adjacent to each other.

*FIG.1*

17 Nb OR Nb-ALLOY  18 Cu
19 Nb SINGLE CORE
11 PRECURSOR
14 Sn-ALLOY  15 Cu
16 Sn SINGLE CORE
19
16
13 BARRIER LAYER
12 CU TUBE

EP 2 448 029 A2

**Description**

The present application is based on Japanese Patent Application No. 2010-242379 filed on October 28, 2010, the entire contents of which are incorporated herein by reference.

BACKGROUND OF THE INVENTION

1. FIELD OF THE INVENTION

The present invention relates to a precursor for a $Nb_3Sn$ superconductor wire having high critical current density (Jc) property to be applicable for a high-field magnet, a $Nb_3Sn$ superconductor wire using the same, and a method for fabricating a $Nb_3Sn$ superconductor wire. Herein, the "precursor" is a structure prior to final formation of the superconductor wire by the heat treatment.

2. RELATED ART

As a method for manufacturing a $Nb_3Sn$ superconductor wire, the bronze method has been used widely. The bronze method is a method including steps of forming a wire with a configuration in which a lot of Nb filaments are disposed within Cu-Sn based alloy, i.e. so-called bronze matrix, diffusing Sn of the Cu-Sn based alloy into the Nb filaments by heat0000000 treatment to form $Nb_3Sn$ in some portions of the Nb filaments, thereby providing a superconductor wire.

However, since an upper limit of solubility limit of Sn in the Cu-Sn based alloy is about **16**% by weight, it is not possible to generate $Nb_3Sn$ to be greater than **16**% by weight, so that there is a limit in critical current value (Ic).

Therefore, the internal Sn diffusion methods for providing more Sn by using a source of Sn other than Cu-Sn based alloy have been developed.

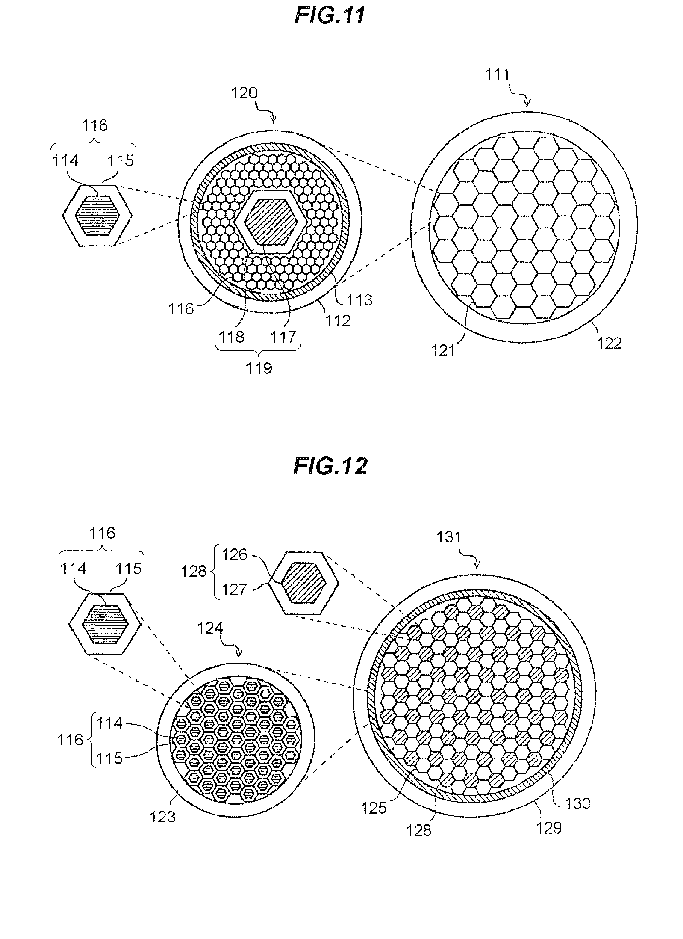

Referring to **FIG. 11**, one of the internal Sn diffusion methods will be explained as follows. A plurality of Nb single cores (monofilaments) **116**, each of which is formed by coating Nb-alloy **114** with Cu **115**, are disposed within a Cu matrix (Cu tube) **112** including a barrier layer **113** made of Ta-alloy or the like at its inner surface. A Sn core **119** formed by coating Sn or Sn-alloy **117** with Cu **118** is disposed as Sn source at a center portion of the Cu matrix **112**, to provide a multicore billet **120**. The multicore billet **120** is reduced in area to provide sub-element wires **121**. The sub-element wires **121** are disposed in a Cu tube **122**, to provide a precursor **111**. A multicore strand (precursor wire rod) is formed by using the precursor **111**. Thereafter, the multicore strand is heat-treated, so that Sn is diffused from the Sn layer (Sn core **119**) via the Cu matrix **112** into the Nb monofilaments **116**. As a result, a $Nb_3Sn$ filament (wire rod) is formed in the portion of the Nb monofilaments **116**.

Referring to **FIG. 12**, another internal Sn diffusion method will be explained below. A plurality of Nb single cores (monofilaments) **116** each of which is formed by coating Nb-alloy **114** with Cu **115** are disposed within a Cu matrix (Cu tube) **123** to provide a multicore billet **124**. The multicore billet **124** is reduced in area to provide sub-element wires **125**. The sub-element wires **125** and Sn single cores (monofilaments) **128**, each of which includes Sn **126** (or further comprises Cu **127** at its outer periphery), are disposed in a Cu tube **129** including a barrier layer **130** at its inner surface, to provide a precursor **131**. A multicore strand (precursor wire rod) is formed by using the precursor **131**. Such a method is disclosed by e.g. Japanese Patent Laid-Open No. 2006-4684 (JP-A 2006-4684).

According to the internal Sn diffusion method, it is possible to increase a proportion of Sn composite material compared to the bronze method, so that a high characteristic e.g. non-Cu Jc (the critical current density in the non-copper part area) =2900 A/mm$^2$ in 12 T (tesla) as the critical current density (Jc) of the wire rod is obtained. For example, such a method is disclosed by J. A. Parrell et al., "Highfield Nb3Sn conductor development at Oxford Superconducting Technology " IEEE Trans. Appl. Supercond., 2003, vol. 13, No. 2, pp. 3470 - 3473.

Further, there are non-patent documents such as "Chronological Scientific Tables" by National Astronomical Observatory, Maruzen, and Yoshio Kubo et al. "Analysis of bridging generating mechanism of Nb3Sn filament by the internal diffusion method", Cryogenics Asian, vol. 31, No. 6, 1996, pp.306-313.

SUMMARY OF THE INVENTION

In the two methods as described above, a lot of Nb filaments are disposed around each Sn filament (i.e. the Sn core **119** in **FIG. 11** or the Sn monofilaments **128** in **FIG. 12**). In other words, the Sn filament having a larger size compared to a size of the Nb filament is incorporated. For example, in the case that the first approach for providing the strand in which a lot of Nb filaments are provided around the Sn core is used, several tens to several hundreds of Nb filaments are provided around one Sn core.

A proportion of Nb to Sn for appropriately generating $Nb_3Sn$ is 3:1 in mole ratio. Here, this ratio is converted into a volume ratio namely a cross-sectional ratio, so that the proportion of Nb to Sn in the cross-sectional ratio is theoretically about 2:1.

Next, formulas on which the above conversion is based will be explained below.

The volume of a material is expressed as follows by using the mole number, atomic weight, and density of the material.

$$\text{Volume} = \text{mole numbers} \times \text{atomic weight} / \text{density}$$

Therefore, the volume ratio of Nb to Sn is expressed as follows.

$$\text{Volume ratio of Nb to Sn} = (\text{Nb mole number} \times \text{Nb atomic weight} / \text{Nb density}) / (\text{Sn mole number} \times \text{Sn atomic weight} / \text{Sn density})$$

According to "Chronological Scientific Tables" by National Astronomical Observatory, Maruzen, the atomic weight and density of Nb are 92.91 and 8.57g/cm$^3$, and the atomic weight and density of Sn are 118.71 and 7.31g/cm$^3$, respectively. When the mole number of Nb is 3 and the mole number of Sn is 1, the volume ratio of Nb to Sn is calculated as follows.

$$\text{Volume ratio of Nb to Sn} = (3 \times 92.91/8.57) / (1 \times 118.71/7.31) \approx 2.0$$

Therefore, in the case that the number of the Nb filaments is 200, a cross-sectional area of Sn required for reacting with 200 Nb filaments to generate Nb$_3$Sn is a half of 200 Nb filaments, namely, a cross-sectional area corresponding to that of 100 Nb filaments. Therefore, in the case that the Sn filament is a single core (monofilament), an outer diameter the Sn filament should be 10-times greater than an outer diameter of Nb filament. Namely, the size of the Sn filament is remarkably greater than the size of the Nb filament.

Further, main materials composing a cross-section of the superconductor filament are Nb, Cu and Sn. Among these elements, Sn is extremely soft as compared with Nb and Cu, and easily deformable.

Therefore, in the case of using the aforementioned configuration that numerous Nb filaments with smaller diameter than that of the Sn core are provided around a single Sn core, there will be following problems. Namely, after assembling the multicore billet, the multicore billet is reduced in area by extrusion or drawing process to provide a wire rod with a predetermined diameter. At this time, if a shape of the Sn core is deformed in the wire rod cross-section, disposition of the numerous Nb filaments around the Sn core will be disordered, thereby causing non-uniformity in superconducting characteristics. This tendency is remarkable when the size of Sn filament with respect to the size of Nb filament is increased.

Further, according to the internal Sn diffusion method, Sn of the Sn element is diffused into Cu provided around the Sn element by heat treatment, to generate Cu-Sn based alloy or Cu-Sn based compound. Thereafter, Sn is diffused into the Nb filaments to generate Nb$_3$Sn. However, the melting point of Sn alone is about 230°C and remarkably lower than Nb$_3$Sn generation heat treatment temperature which is 650 to 750°C. As to the Cu-Sn based alloy or the Cu-Sn based compound generated in the process of Sn-diffusion, liquid phase is partially generated at the Nb$_3$Sn heat treatment temperature when Sn content is high.

Therefore, the Nb multicore in the sub-element of the strand is occasionally surrounded by the liquid phase or soft Cu-Sn based alloy including the liquid phase during the heat treatment. Particularly, the Nb filament in a portion contacting an outer perimeter moves to the liquid phase, so that there is a problem that the superconducting characteristics are deteriorated. This tendency is also remarkable when the size of the Sn filament with respect to the size of the Nb filament is increased, as pointed out by Kubo et al.

In addition, it is often found that gaps (voids) are left on traces of diffusion of Sn into Nb. As described above, there are some cases that the void having a size greater than the size of the Nb filament may be generated in the superconductor wire manufactured by the conventional internal Sn diffusion method, since the size of the Sn filament is larger than the size of the Nb filament. When the superconductor wire is used as a superconducting magnet, strong magnetic field is applied to the superconductor wire, so that large electromagnetic force is applied to the Nb$_3$Sn filament through which superconducting current flows. If the voids exist in the vicinity of the filament, the filament subjected to the large electromagnetic force may move, so that the superconducting state of the wire rod may be broken suddenly and turn into the normal conducting state (so-called "quench phenomenon"), or the characteristics of the wire rod may be deteriorated. It may disturb the stable energization to the superconductor wire.

Accordingly, an object of the invention is to solve the aforementioned problems, and to provide a precursor for a Nb₃Sn superconductor wire, a Nb₃Sn superconductor wire using the same, and a method for fabricating a Nb₃Sn superconductor wire, by which the disorder of the arrangement of the Nb single cores due to deformation of the Sn single cores in the drawing process, the disorder of the arrangement of Nb single cores due to melting of Sn by the heat treatment, and the size of voids generated in the Sn single cores due to the heat treatment at the time of manufacturing the Nb₃Sn superconductor wire by the internal Sn diffusion method are reduced, thereby suppressing deterioration in the superconducting characteristics.

(**1**) According to a feature of the invention, a precursor for a Nb₃Sn superconductor wire to be manufactured by the internal Sn diffusion method comprises:

> a Cu tube comprising a barrier layer at an inner surface thereof, the barrier layer comprising a metal selected from the group consisting of Ta, Ta-alloy, Nb and Nb-alloy,
> a plurality of Sn single cores disposed in the Cu tube, each of the Sn single cores comprising Sn or Sn-alloy; and
> a plurality of Nb single cores disposed in the Cu tube, each of the Nb single cores comprising Nb or Nb-alloy, in which the Sn single cores and the Nb single cores are arranged in the Cu tube such that the Sn single cores are not adjacent to each other.

(**2**) In the precursor for a Nb₃Sn superconductor wire, each of the Sn single cores may further comprise a Cu layer coating the Sn or the Sn-alloy.
(**3**) In the precursor, each of the Nb single cores may further comprise a Cu layer coating the Nb or the Nb-alloy.
(**4**) In the precursor for a Nb₃Sn superconductor wire, each of the Sn single cores are preferably separated from each other.
(**5**) In the precursor for a Nb₃Sn superconductor wire, the Nb single cores may be disposed to surround each of the Sn single cores.
(**6**) The precursor for a Nb₃Sn superconductor wire may further comprise a plurality of Cu single cores disposed in the Cu tube.
(**7**) In the precursor for a Nb₃Sn superconductor wire, it is preferable that a diameter of each of the Sn single core and a diameter of each of the Nb single core in a cross-section of the Cu tube accommodating the Sn single cores and the Nb single cores after drawing process are 30 μm or less, respectively.
(**8**) In the precursor for a Nb₃Sn superconductor wire, it is preferable that a ratio of a cross-sectional area of each of the Nb single cores to a cross-sectional area of each of the Sn single cores is within a range of 0.3 to 2.2.
(**9**) In the precursor for a Nb₃Sn superconductor wire, a ratio of total cross-sectional area of the Nb single cores to a total cross-sectional area of the Sn single cores is preferably within a range of 1.2 to 2.2.
(**10**) According to another feature of the invention, a Nb₃Sn superconductor wire is manufactured by heat treating the precursor according to (**1**).
(**11**) According to another feature of the invention, a method for manufacturing a Nb₃Sn superconductor wire comprises:

> conducting area reduction on a Cu pipe to which a Nb rod or a Nb-alloy rod is inserted, thereby providing Nb single cores;
> conducting area reduction on a Sn rod or a Sn-alloy rod, thereby providing Sn single cores;
> forming a barrier layer comprising a metal selected from the group consisting of Ta, Ta-alloy, Nb and Nb-alloy at an inner surface of a Cu tube;
> disposing the Nb single cores and the Sn single cores in the Cu tube having the barrier layer, such that the Nb single cores surround each of the Sn single cores and the Sn single cores are not adjacent to each other, thereby providing a precursor;
> drawing the precursor, thereby providing a precursor wire; and heat treating the precursor wire.

(**12**) In the method according to the feature (**11**), the Sn rod or the Sn-alloy rod may be inserted into another Cu pipe before conducting the area reduction on the Sn rod or the Sn-alloy rod.
(**13**) According to still another feature, a method for manufacturing a Nb₃Sn superconductor wire comprises:

> conducting area reduction on a Cu pipe to which a Nb rod or a Nb-alloy rod is inserted, thereby providing Nb single cores;
> conducting area reduction on a Sn rod or a Sn-alloy rod, thereby providing Sn single cores;
> forming a barrier layer comprising a metal selected from the group consisting of Ta, Ta-alloy, Nb and Nb-alloy at an inner surface of a Cu tube;

disposing the Nb single cores and the Sn single cores in the Cu tube having the barrier layer, such that Sn single cores are not adjacent to each other, thereby providing a multicore billet;

conducting area reduction on the multicore billet, thereby providing sub-element wires;

bundling and inserting the sub-element wires into a Cu tube, thereby forming a precursor;

drawing the precursor, thereby forming a precursor wire; and heat treating the precursor wire.

(**14**) In the method according to the feature (**13**), the Sn rod or the Sn-alloy rod may be inserted into another Cu pipe before conducting the area reduction on the Sn rod or the Sn-alloy rod.

According to a still another feature of the present invention, a method for manufacturing a $Nb_3Sn$ superconductor wire comprises:

conducting area reduction on a Cu pipe to which a Nb rod or a Nb-alloy rod is inserted, thereby providing Nb single cores;

conducting area reduction on a Sn rod or a Sn-alloy rod, thereby providing Sn single cores;

disposing the Nb single cores and the Sn single cores in a Cu tube, such that Sn single cores are not adjacent to each other, thereby providing a multicore billet;

conducting area reduction on the multicore billet, thereby providing sub-element wires;

forming a barrier layer comprising a metal selected from the group consisting of Ta, Ta-alloy, Nb and Nb-alloy at an inner surface of another Cu tube;

bundling and inserting the sub-element wires into the Cu tube having the barrier layer, thereby forming a precursor;

drawing the precursor, thereby forming a precursor wire; and

heat treating the precursor wire.

(**15**) In the method according to the feature (**14**), the Sn rod or the Sn-alloy rod may be inserted into another Cu pipe before conducting the area reduction on the Sn rod or the Sn-alloy rod.

(Points of the Invention)

According to the invention, the Sn single cores and the Nb single cores are arranged such that the Sn single cores are not adjacent to each other, namely, separated from each other, it is possible to provide a precursor for a $Nb_3Sn$ superconductor wire, a $Nb_3Sn$ superconductor wire using the same, and a method for fabricating a $Nb_3Sn$ superconductor wire, by which the disorder of the arrangement of the Nb single cores due to deformation of the Sn single cores in the drawing process, the disorder of the arrangement of Nb single cores due to melting of Sn by the heat treatment, and the size of voids generated in the Sn single core due to the heat treatment at the time of manufacturing the $Nb_3Sn$ superconductor wire by the internal Sn diffusion method are reduced, thereby suppressing deterioration in the superconducting characteristics.

BRIEF DESCRIPTION OF THE DRAWINGS

Next, a precursor for a $Nb_3Sn$ superconductor wire, a $Nb_3Sn$ superconductor wire using the same, and a method for fabricating a $Nb_3Sn$ superconductor wire in an embodiment according to the invention will be explained in conjunction with appended drawings, wherein:

FIG. 1 is a cross-sectional view of a precursor for $Nb_3Sn$ superconductor wire in the first embodiment according to the present invention, showing a configuration in which a proportion in number of Sn single cores and Nb single cores is 1:2;

FIG. 2 is a cross-sectional view of a precursor for a $Nb_3Sn$ superconductor wire in the second embodiment according to the present invention, showing a configuration in which a proportion in number of Sn single cores and Nb single cores is 1:3;

FIG. 3 is a cross-sectional view of a precursor for $Nb_3Sn$ superconductor wire in the third embodiment according to the present invention, showing a configuration in which a proportion in number of Sn single cores and Nb single cores is 1:4;

FIG. 4 is a cross-sectional view of a precursor for a $Nb_3Sn$ superconductor wire in a reference example according to the present invention, showing a configuration in which a proportion in number of Sn single cores and Nb single cores is 1:6;

FIG. 5 is a cross-sectional view of a precursor for a $Nb_3Sn$ superconductor wire in the fourth embodiment according to the present invention, showing a configuration in which a proportion in number of Sn single cores, Nb single cores and Cu single cores is 1:1:1;

FIG. 6 is a cross-sectional view of a precursor for a $Nb_3Sn$ superconductor wire in the fifth embodiment according to the present invention, showing a configuration in which a proportion in number of Sn single cores, Nb single cores and Cu single cores is 1:2:1;

FIG. 7 is a cross-sectional view of a precursor for a $Nb_3Sn$ superconductor wire in the sixth embodiment according to the present invention, showing a configuration in which a proportion in number of Sn single cores, Nb single cores and Cu single cores is 2:3:1;

FIG. 8 is a cross-sectional view of a precursor for a $Nb_3Sn$ superconductor wire in the seventh embodiment according to the present invention, showing a configuration in which sub-element wires manufactured from a multicore billet are incorporated;

FIG. 9 is a cross-sectional view of a precursor for a $Nb_3Sn$ superconductor wire in the eighth embodiment according to the present invention, showing a configuration in which sub-element wires manufactured from a multicore billet are incorporated;

FIG 10 is a photomicrograph of a $Nb_3Sn$ superconductor wire obtained in Example 1 of the present invention;

FIG. 11 is a cross-sectional view of a precursor for a $Nb_3Sn$ superconductor wire manufactured by a conventional internal Sn diffusion method; and

FIG. 12 is a cross-sectional view of a precursor for a $Nb_3Sn$ superconductor wire manufactured by another conventional internal Sn diffusion method.

## DETAILED DESCRIPTION OF THE EMBODIMENT

(Theoretical explanation of the present invention)

The present invention is characterized in that a plurality of Nb monofilaments (Nb single cores) and a plurality of Sn monofilaments (Sn single cores) are respectively bundled to be a composite member, such that the Sn single cores are arranged not to be adjacent to each other, namely, separated from each other in the process of manufacturing the $Nb_3Sn$ multicore strand by the internal Sn diffusion method.

According to this structure, the size of the Sn single core may be determined to be substantially equal to the size of the Nb single core, thereby reducing the disorder in arrangement of the Nb single cores when the Sn single cores are deformed. Similarly, since the size of the Sn single core is substantially equal to the size of the Nb single core, it is possible to reduce the disorder in arrangement of the Nb single cores when the Sn single cores are melted by the heat treatment. Further, it is possible to improve the stability of the $Nb_3Sn$ filament when the electromagnetic force is applied thereto, by decreasing the size of the voids generated in the Sn single core to be less than the size of the Nb single core.

In the $Nb_3Sn$ filament generated by the heat treatment, the size thereof is reduced so as to reduce AC loss and stabilize the superconducting characteristics. Therefore, superfine multicore strands, each of which has a single core diameter of about 5 $\mu$m, have been conventionally manufactured by using the bronze method. The diameter of the single core should be designed according to the application use. For using the single core for a superconducting magnet, since it is necessary to prevent the superconducting state from being broken due to decrease and increase in the magnetic field, the diameter of the Nb single core in the precursor after the drawing process is preferably 30 $\mu$m or less. Since the present invention is characterized in that the diameter of the Sn single core is substantially equal to the diameter of Nb single core, the diameter of Sn single core is preferably 30 $\mu$m or less.

Herein, the cross-sectional configuration of each filament after the drawing process does not keep an original hexagonal shape due to the drawing process. Therefore, the "diameter" (or the "size") in the present application is expressed as an average value of the longest length (maximum length) in the cross-section of each filament and the longest length (maximum length) of a portion along a direction orthogonal to the maximum length in the cross-section.

According to the present invention, it is possible to manufacture the $Nb_3Sn$ superconductor wire to satisfy that a ratio of a total cross-sectional area of the Nb single cores (Nb total cross-sectional area) and a total cross-sectional area of the Sn single cores (Sn total cross-sectional area) (i.e. [the Nb total cross-sectional area] / [the Sn total cross-sectional area] (hereinafter, referred to as "total cross-sectional area ratio") is within a range of 1.2 to 2.2. The mole ratio of Nb to Sn (the proportion of Nb to Sn) by which the $Nb_3Sn$ is properly generated is 3, which is expressed as 2 in volume ratio as described above. However, the Inventors found that the superconducting wire with excellent characteristics (the critical current value Ic and the filament critical current density Jc) can be obtained by determining the total cross-sectional area ratio to be 1.2 to 2.2 as a result of zealous studies.

In the present invention, the volume ratio is assumed not to vary substantially before and after the heat treatment. In other words, the total cross-sectional area ratio is substantially equivalent to the volume ratio.

It will be sufficient to react Nb with Sn to generate $Nb_3Sn$ in just proportion after the heat treatment if the total cross-sectional area ratio of Nb to Sn is just 2. Further, it is possible to increase the proportion of Sn so as to improve the superconducting characteristics, or to increase the proportion of Nb so as to retain non-reacted Nb at a center portion of $Nb_3Sn$, thereby improving mechanical strength of the superconducting wire. More preferably, the total cross-sectional area ratio of the Nb single core to the Sn single core is 1.4 to 2.0.

Further, in the present invention, as to methods for arranging the Sn single cores such that the Sn single cores are not disposed to be adjacent to each other (i.e. do not come into contact with each other), in other words, to be separated from each other, following methods may be used. For example, one Nb single core may be disposed for one Sn single core, two Nb single cores may be disposed for one Sn single core, three Nb single cores may be disposed for one Sn single core, or four Nb single cores may be disposed for one Sn single core.

Therefore, a ratio of a cross-sectional area of each Nb single core to a cross-sectional area of each Sn single core is calculated by dividing the ratio of the total cross-sectional area of the Nb single cores to the total cross-sectional area of the Sn single cores which is within a range of 1.2 to 2.2 by the ratio of the number of the Nb single cores to the number of the Sn single cores, which is 1 to 4. Therefore, a ratio of a cross-sectional area of each of the Nb single cores to a cross-sectional area of each of the Sn single cores is preferably within a range of 0.3 to 2.2.

Next, the embodiments according to the present invention based on the above studies will be explained below in more detail in conjunction with appended drawings.

(First embodiment)

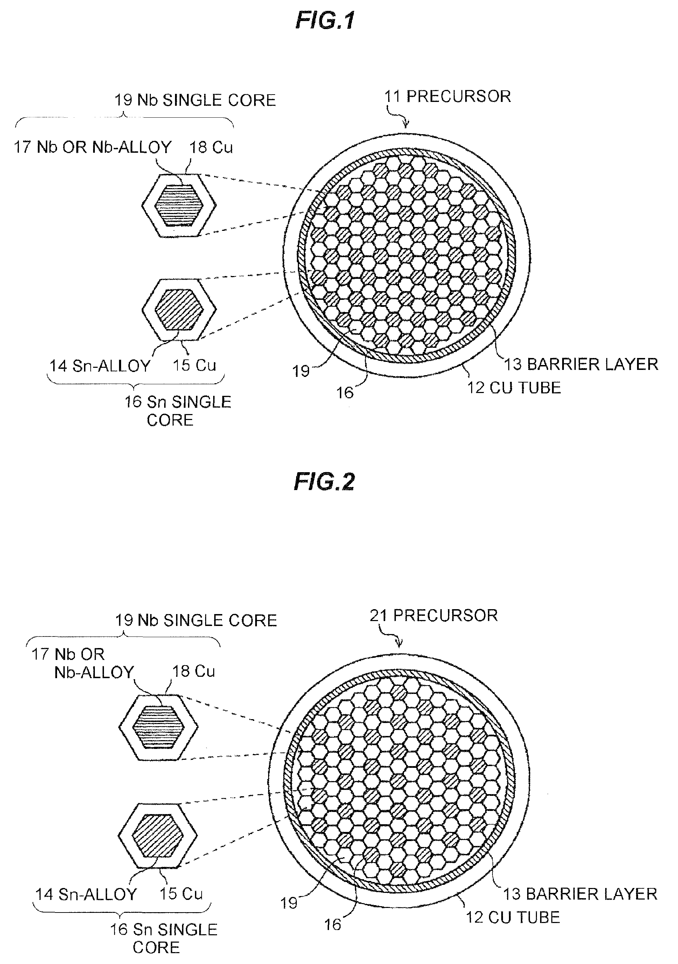

**FIG. 1** is a cross-sectional view of a precursor for a $Nb_3Sn$ superconductor wire in the first embodiment according to the present invention, showing a configuration in which a proportion in number of Sn single cores and Nb single cores is 1:2.

Referring to **FIG. 1**, a precursor **11** for a $Nb_3Sn$ superconductor wire includes a Cu tube **12** having a barrier layer **13** comprising one metal selected from the group consisting of Ta, Ta-alloy, Nb, and Nb-alloy at its inner surface, a plurality of Sn single cores **16,** each of which comprises Sn-alloy or further comprises Cu **15** coating the Sn-alloy **14,** and a plurality ofNb single cores **19**, each of which comprises Nb or Nb-alloy **17** or further comprises Cu **18** coating the Nb or Nb-alloy **17**, in which the Sn single cores **16** and the Nb single cores are arranged in the Cu tube **12**, such that the Sn single cores are not adjacent to each other, namely, do not come into contact with each other. In other words, the Sn single cores **16** are distant and separated from each other. The Sn single core **16** may comprise Sn, and further comprises Cu **15** coating Sn.

Herein, each of the Sn single cores **16** and the Nb single cores **19** has a hexagonal cross-section. However, the present invention is not limited thereto. The cross-section of each of the Sn single cores **16** and the Nb single cores **19** may have a shape other than hexagonal shape.

Referring to **FIG. 1**, the cross-sectional area of each Sn single core **16** is same as the cross-sectional area of each Nb single core **19**, and the proportion in number of the Sn single cores **16** to the Nb single cores **19** is 1:2. Namely, the Sn single cores **16** and the Nb single cores **19** are arranged in the Cu tube **12**, such that a proportion of a total volume of the Nb single cores to a total volume of the Sn single cores (i.e. a proportion of the total cross-sectional area of Nb to the total cross-sectional area of Sn (hereinafter, referred to as "total cross-sectional area ratio")) is **2**.

According to the precursor **11** having the aforementioned configuration, it is possible to suppress the disorder in the arrangement of the Nb single cores **19** due to instable deformation of the Sn single cores **16** in the wire drawing process, so that it is possible to prevent the non-uniformity of the superconducting characteristics in the $Nb_3Sn$ superconductor wire manufactured by the heat treatment.

(Second and third embodiments)

The configuration of the precursor for a $Nb_3Sn$ superconductor wire in the present invention is not limited to the configuration shown in **FIG.1.**

**FIG. 2** is a cross-sectional view of a precursor **21** for a $Nb_3Sn$ superconductor wire in the second embodiment according to the present invention, showing a configuration in which a proportion in number of the Sn single cores **16** and the Nb single cores **19** is 1:3.

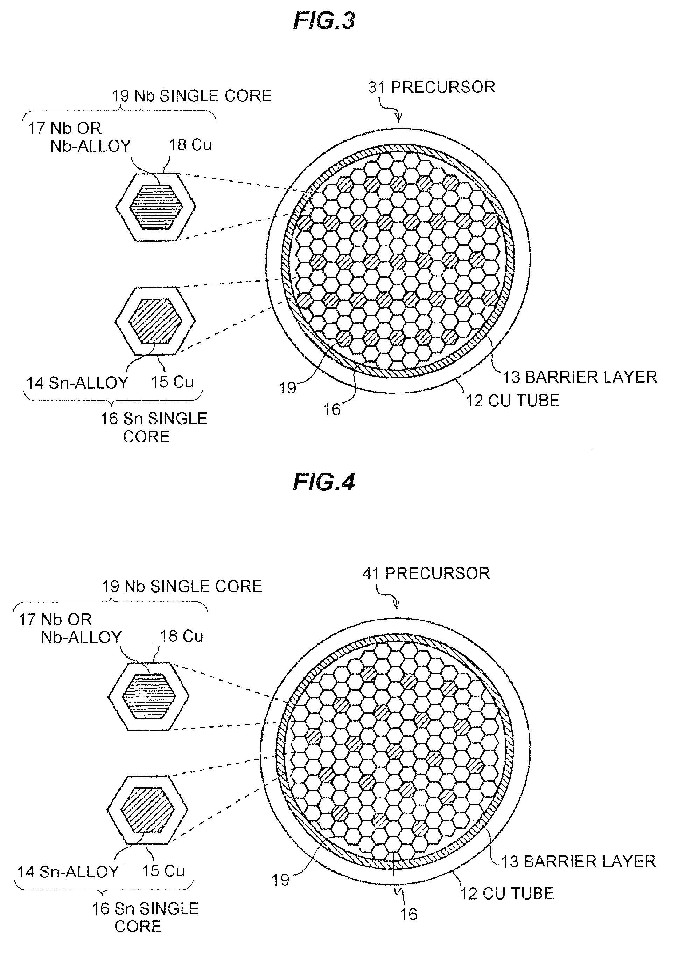

**FIG. 3** is a cross-sectional view of a precursor **31** for $Nb_3Sn$ superconductor wire in the third embodiment according to the present invention, showing a configuration in which a proportion in number of the Sn single cores **16** and the Nb single cores **19** is 1:4.

In FIGS. **2** and **3**, the cross-sectional area of each Sn single core **16** and the cross-sectional area of each Nb single core **19** are illustrated to be the same for the explanation purpose. In fact, the cross-sectional area of each Nb single core **19** is reduced in accordance with the proportion in number of the Nb single cores **19** to the Sn single cores **16** such that the ratio of the total cross-sectional area of the Nb single cores to the total cross-sectional area of the Sn single cores is within a range of 1.2 to 2.2.

Namely, in the precursor **21** shown in **FIG. 2**, since the proportion in number of the Sn single cores and the Nb single cores is 1:3, the proportion of the cross-sectional area of each Nb single core **19** to the cross-sectional area of each Sn single core **16** is within a range of over 0.5 to 0.8 such that the ratio of the total cross-sectional area of the Nb single cores to the total cross-sectional area of the Sn single cores is within a range of 1.2 to 2.2.

Similarly, in the precursor **31** shown in **FIG. 3**, since the proportion in number of the Sn single cores and the Nb single cores is 1:4, the proportion of the cross-sectional area of each Nb single core **19** to the cross-sectional area of each Sn single core **16** is within a range of 0.3 to 0.6 such that the ratio of the total cross-sectional area of the Nb single cores to the total cross-sectional area of the Sn single cores is within a range of 1.2 to 2.2.

(Reference example)

**FIG. 4** is a cross-sectional view of a precursor **41** for a $Nb_3Sn$ superconductor wire in the reference example according to the present invention, showing a configuration in which a proportion in number of the Sn single cores **16** and the Nb single cores **19** is 1:6.

For arranging the Sn single cores **16** and the Nb single cores **19** in the Cu tube **12** such that the respective Sn single cores **16** are not adjacent to each other (and do not come into contact with each other), it is also possible to increase the proportion in number of the Nb single cores **19** to the Sn single cores **16**, e.g. configuring the precursor **41** in which the proportion in number of the Nb single cores **19** to the Sn single cores **16** is 6:1 as shown in **FIG. 4**. However, it is necessary to reduce the ratio of the cross-sectional area of each Nb single core **19** to the cross-sectional area of each Sn single core **16**, so as to determine the ratio of the total cross-sectional area of the Nb single cores **19** to the total cross-sectional area of the Sn single cores **16** for generating $Nb_3Sn$ in just proportion. In **FIG. 4**, it is necessary to determine the ratio of the cross-sectional area of each Nb single core **19** to the cross-sectional area of each Sn single core **16** to be 1:3. However, in the precursor **41**, in which the cross-section of each Nb single core **19** is reduced, the disorder in the arrangement of the single cores in the process of reducing the area is increased and the size of the voids generated during the heat treatment is increased as described above, thereby deteriorating the superconducting characteristics. Accordingly, such a configuration is not favorable. Therefore, the proportion in number of the Nb single cores **19** to the Sn single cores **16** is within a range of 1:1 to 4:1.

According to the present invention, clearances may be generated between the Sn single cores **16** because of variation in the area ratio between the Sn single cores **16** and the Nb single cores **1**. In such a case, it is possible to prevent that the respective Sn single cores **16** from contacting to each other by providing narrow Cu dummy filaments in the clearances between the Sn single cores **16**.

(Fourth to sixth embodiments)

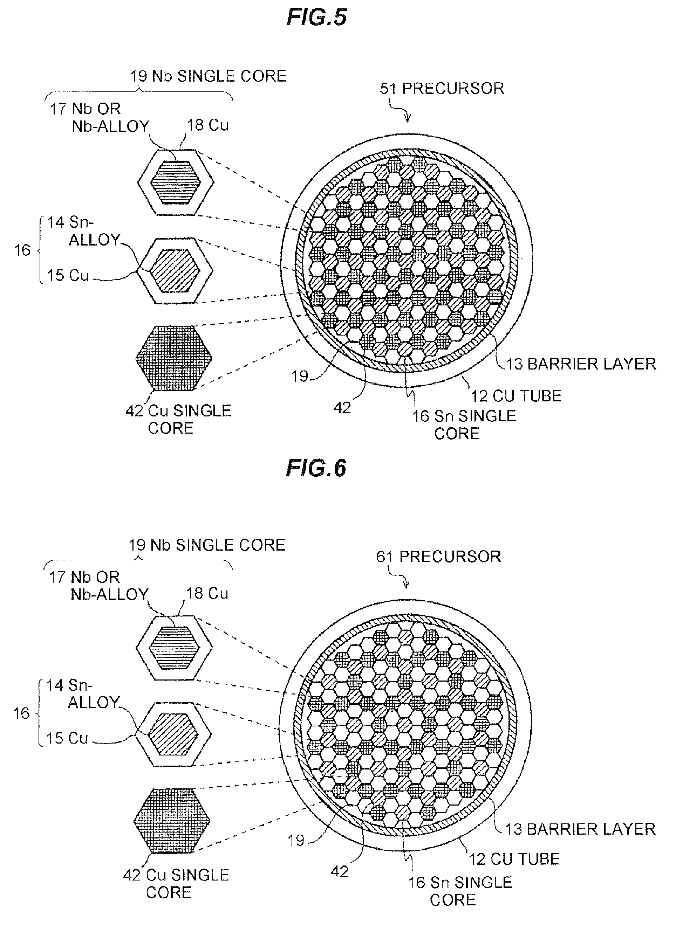

**FIG. 5** is a cross-sectional view of a precursor **51** for a $Nb_3Sn$ superconductor wire in the fourth embodiment according to the present invention, showing a configuration in which a proportion in number of the Sn single cores **16**, the Nb single cores **19** and Cu single cores **42** is 1:1:1.

**FIG. 6** is a cross-sectional view of a precursor **61** for a $Nb_3Sn$ superconductor wire in the fifth embodiment according to the present invention, showing a configuration in which a proportion in number of the Sn single cores **16**, the Nb single cores **19** and the Cu single cores **42** is 1:2:1.

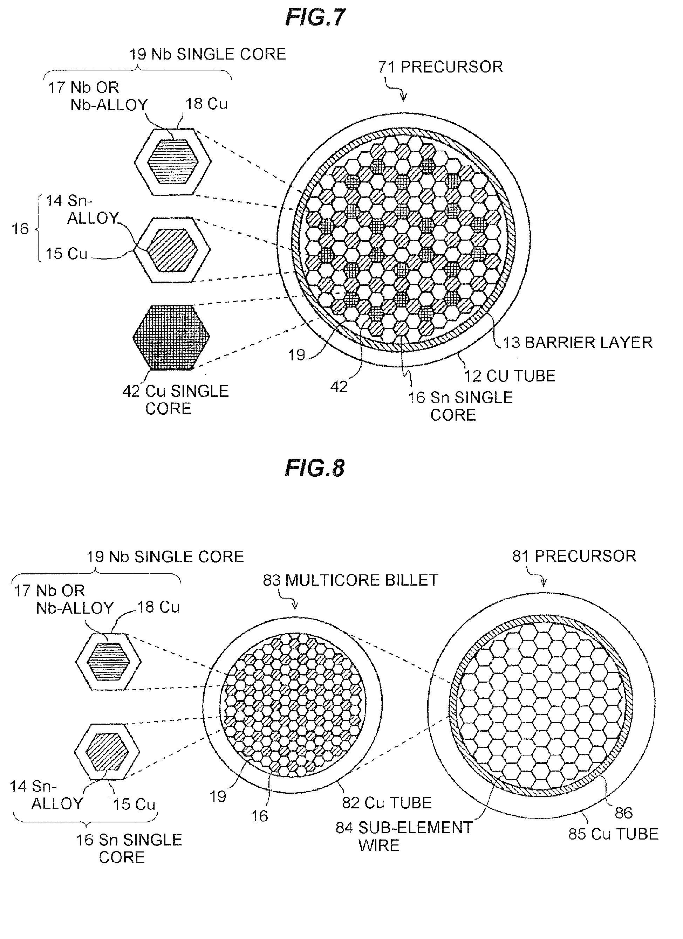

**FIG. 7** is a cross-sectional view of a precursor for a $Nb_3Sn$ superconductor wire in the sixth embodiment according to the present invention, showing a configuration in which a proportion in number of the Sn single cores **16**, the Nb single cores **19** and the Cu single cores **42** is 2:3:1,

In the present invention, the Cu single cores **42** are provided in addition to the Sn single cores **16** and the Nb single cores **19** within the Cu tube **12** having the barrier layer **13** at its inner surface, such that the Sn single cores **16** are not adjacent to each other (do not come into contact with each other), to provide the precursors **51**, **61** and **71**, as shown in FIGS. 5 to 7, respectively. In other words, a precursor **51**, **61** or **71** for a $Nb_3Sn$ superconductor wire further includes the Cu single cores **42** to be disposed in the Cu tube **12**.

Each of the precursors **51**, **61**, and **71** shown in FIGS. 5 to 7 has a configuration in which a part of the Nb single cores **19** in the precursor **11** shown in **FIG. 1** is replaced with the Cu single cores **42**.

Referring to **FIG. 5**, in the precursor **51** for a $Nb_3Sn$ superconductor wire, a proportion in number of the Sn single cores **16**, the Nb single cores **19** and the Cu single cores **42** is 1:1:1, and the Cu single cores **42** are disposed within the Cu tube **12** having the barrier layer **13** at its inner surface.

Referring to **FIG 6**, in the precursor **61** for a $Nb_3Sn$ superconductor, the proportion in number of the Sn single cores **16**, the Nb single cores **19** and the Cu single cores **42** is 1:2:1, and the Sn single cores **16**, the Nb single cores **19**, and the Cu single cores **42** are disposed within the Cu tube **12** having the barrier layer **13** at its inner surface.

Referring to **FIG 7**, in the precursor **71** for a $Nb_3Sn$ superconductor wire, the proportion in number of the Sn single cores **16**, the Nb single cores **19** and the Cu single cores **42** is 2:3:1, and the Cu single cores **42** are disposed within the Cu tube **12** having the barrier layer **13** at its inner surface.

According to such configuration, the critical current value Ic of the superconductor wire is reduced, since a volume ratio of a portion composing the Nb$_3$Sn superconductor after the heat treatment to the precursor is reduced. On the other hand, at the time of the drawing process (or the area reduction process) of the precursor **51**, **61**, or **71**, it is possible to deform the Sn single cores **16** more stably than the precursor **11**, so that it is possible to prevent the disorder in the arrangement of the single cores after the processing, and the deterioration in the superconducting characteristics of the superconductor wire manufactured by the aforementioned process.

(Seventh and eighth embodiments)

**FIG. 8** is a cross-sectional view of a precursor **81** for a Nb$_3$Sn superconductor wire in the seventh embodiment according to the present invention, showing a configuration in which sub-element wires **84** manufactured from a multicore billet **83** are incorporated.

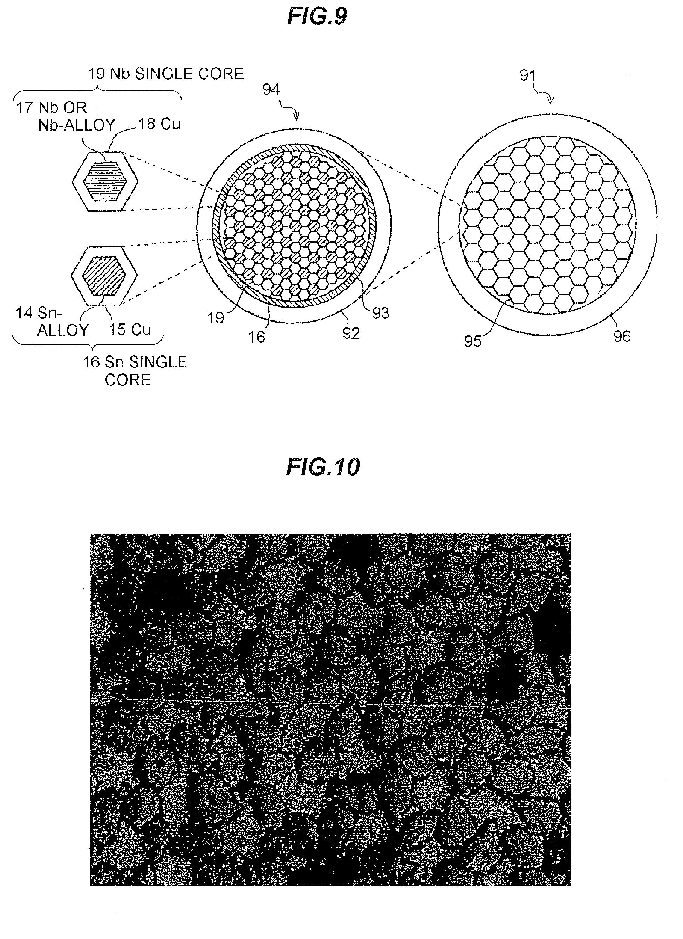

**FIG 9** is a cross-sectional view of a precursor **91** for a Nb$_3$Sn superconductor wire in the eighth embodiment according to the present invention, showing a configuration in which sub-element wires **95** manufactured from a multicore billet **94** are incorporated.

In the seventh and eighth embodiments according to the present invention, the Sn single cores **16** and the Nb single cores **19** may be disposed within a Cu tube **82**, **92**, to provide a multicore billet **83**, **94**, and the multicore billet **83**, **94** may be drawn to be reduced in area to provide sub-element wires **84**, **95**. A plurality of sub-element wires **84**, **95** may be disposed in another Cu tube **85**, **96**, to provide a precursor **81**, **91** for a superconductor wire.

For example, referring to **FIG. 8**, the Sn single cores **16** and the Nb single cores **19** are disposed within the Cu tube **82** such that the Sn single cores **16** are not adjacent to each other, to provide the multicore billet **83**, and the multicore billet **83** is drawn to be reduced in area to provide the sub-element wires **84**. The sub-element wires **84** are disposed in the Cu tube **85** having a barrier layer **86** at its inner surface, to provide the precursor **81** for a superconductor wire.

Referring to **FIG. 9**, the Sn single cores **16** and the Nb single cores **19** are disposed within the Cu tube **92** having a barrier layer **93** at its inner surface such that the Sn single cores **16** are not adjacent to each other, to provide the multicore billet **94**, and the multicore billet **94** is drawn to be reduced in area to provide the sub-element wires **95**. The sub-element wires **95** are disposed in the Cu tube **96**, to provide the precursor **91** for a superconductor wire.

In the superconductor wire obtained by processing the precursor **81** or **91** by the area reduction process and the heat treatment, a diameter ofNb single core **19** is reduced, diffusion of Sn atoms into the Nb single core **19** is enhanced, and the superconducting characteristics of the produced superconductor wire can be further improved, compared with the superconductor wire using the precursor **11**, **21**, or **31** without further processing.

The precursors **11**, **21**, **31**, **51**, **61**, **71**, **81**, and **91** according to the invention are suitable for the precursor for fabricating the Nb$_3$Sn superconductor wire. According to the precursors **11**, **21**, **31**, **51**, **61**, **71**, **81**, and **91**, it is possible to suppress the non-uniform deformation of the Sn single cores in the area reduction process, to reduce the size of the voids that may occur in the vicinity of the Sn single core during the heat treatment, and to manufacture the Nb$_3$Sn superconductor wire with excellent superconducting characteristics.

The precursor for a Nb$_3$Sn superconductor wire according to the present invention is not limited to the aforementioned embodiments. The present invention may be provided by combining the aforementioned embodiments.

(Method for fabricating the Nb$_3$Sn superconductor wire)

(Ninth embodiment)

Next, a method for fabricating a Nb$_3$Sn superconductor wire in a ninth embodiment according to the invention will be explained below.

In the fabrication method according to the present invention, a Nb rod or Nb-alloy rod is firstly inserted into a Cu pipe, and this Cu pipe is processed by area reduction process to provide Nb single cores. Alternatively, the Nb rod or Nb-alloy rod may be processed by area reduction process, to provide the Nb single cores. On the other hand, a Sn rod or Sn-alloy rod is processed by area reduction process, to provide Sn single cores. Alternatively, a Sn rod or Sn-alloy rod is inserted into a Cu pipe, this Cu pipe is processed by area reduction process to provide the Sn single cores. According to this process, the Sn single core and the Nb single core are provided.

At this time, the size of the Sn single core and the size of the Nb single core obtained by the above process are determined such that the ratio of the total cross-sectional area of the Nb single cores to the total cross-sectional area of the Sn single cores is within a range of 1.2 to 2.2, and that the ratio of the cross-sectional area of each Nb single core **19** to the cross-sectional area of each Sn single core **16** is within a range of 0.3 to 2.2.

Next, a barrier layer made of Nb, Nb-alloy, Ta, or Ta-alloy is provided at an inner surface of the Cu tube. In the Cu tube, the Nb single cores and the Sn single cores are disposed such that the Nb single cores are provided around a periphery of the Sn single core and the Nb single cores are adjacent to the Sn single core, to provide a precursor. According to this structure, the Sn single cores are not adjacent to each other.

In the present invention, a method of providing the barrier layer in the Cu tube is not limited to the aforementioned method. The barrier layer may be provided by inserting a sheet member into the Cu tube, or inserting a pipe member into the Cu tube.

The precursor obtained by the aforementioned process is further processed by area reduction process to provide a precursor wire (precursor wire rod). By conducting the heat treatment on the precursor wire under predetermined conditions, a Nb$_3$Sn superconductor wire in the present invention can be fabricated.

(Tenth embodiment)

Next, a method for fabricating a Nb$_3$Sn superconductor wire in the tenth embodiment according to the invention will be explained below.

In the present embodiment, similarly to the ninth embodiment, the step of forming the Nb single core and the step of forming the Sn single core are conducted. As a result, the Nb single core and the Sn single core are obtained.

Next, the Nb single cores and the Sn single cores obtained by the aforementioned processes are disposed in a Cu tube such that the Sn single cores are not adjacent to each other, to provide a multicore billet.

A plurality of sub-element wires are formed by conducting the area reduction process on the multicore billet formed by the aforementioned process. Then, the plurality of sub-element wires are disposed in a Cu tube having a barrier layer at its inner surface, to provide a precursor.

The precursor obtained by the aforementioned process is further processed by area reduction process to provide a precursor wire. By conducting the heat treatment on the precursor wire under predetermined conditions, a Nb$_3$Sn superconductor wire in the present invention can be fabricated.

The present embodiment in which the precursor is fabricated by using the sub-element wires may be modified in various ways. For example, at the time of forming the multicore billet by disposing the Sn single cores and the Nb single cores, a barrier layer may be provided in the Cu tube. Thereafter, the Sn single cores and the Nb single cores may be disposed in the Cu tube having the barrier layer at its inner surface to provide the multicore billet. In this case, it is not necessary to provide another barrier tube in another Cu tube for accommodating the sub-element wires formed from the multicore billet.

In the method for fabricating a Nb$_3$Sn superconductor wire according to the present invention, in the case that the cross-sectional area ratio of the Sn single core and the Nb single core is different from each other so that clearances occur between the respective Sn single cores and the Sn single cores may come into contact with each other, narrow Cu dummy filaments may be disposed in the clearances between the Sn single cores. In addition to the Sn single cores and the Nb single cores, the Cu single cores may be disposed in the Cu tube, to provide a precursor or multicore billet.

As described above, in the precursor for a Nb$_3$Sn superconductor wire, the Nb$_3$Sn superconductor wire using the same, and the method for fabricating a Nb$_3$Sn superconductor wire according to the invention, the Sn single cores and the Nb single cores are disposed in the Cu tube such that the Sn single cores are not adjacent to each other (do not come into contact with each other) at the time of forming the precursor or multicore billet. According to this structure, the disorder in arrangement of the single cores due to non-uniform deformation of the Sn single cores in the drawing process and the area reduction process, and the size of the voids which may occur in the vicinity of the Sn single core due to the heat treatment after the drawing process and the area reduction process can be reduced.

(Examples)

Next, Examples of the present invention will be explained below.

(Example **1**)

Referring to **FIG. 1**, a Nb rod with an outer diameter of 26 mm was inserted into a Cu pipe with an outer diameter of 30 mm and an inner diameter of 26.2 mm. Thereafter, the Cu pipe accommodating the Nb rod was processed by the area reduction process to have a hexagonal cross-section in which a spacing between opposite sides is 1 mm, thereby manufactured Nb monofilaments (Nb single cores).

Next, a rod of Sn-alloy material containing Ti of 2% by mass (Sn-2mass%Ti) and having an outer diameter of 26 mm was inserted into a Cu pipe with an outer diameter of 30 mm and an inner diameter of 26.2 mm. Thereafter, the Cu pipe accommodating the Sn-alloy material rod was processed by the area reduction process to have a hexagonal cross-section in which a spacing between opposite sides is 1 mm, thereby manufactured Sn monofilaments (Sn single cores).

Finally, Sn filaments (499 in number) and Nb filaments (499 in number) a total number of which is 1495, i.e.

the ratio in number of the Nb filaments to the Sn filaments is about 2:1 in Example **1**, are disposed in a Cu pipe with an outer diameter of 50 mm and an inner diameter of 44 mm in a dispersing manner. More concretely, one Sn filament was surrounded by a plurality of Nb filaments (6 in number in Example **1**) such that the Sn filaments are not directly adjacent to each other, namely, the Sn filaments are spaced from each other. A Ta-sheet with a thickness of 0.2 mm was provided between the Cu pipe and the filaments as a diffusion barrier layer for preventing Sn from diffusing into Cu surrounding a periphery of Sn, so as to suppress the deterioration in stable superconducting characteristics. The Ta-sheet was wound around the filaments in 5 turns, and inserted into the Cu pipe, to form a multicore composite (precursor). The multicore composite was processed by the area reduction process, to form a multicore wire (precursor wire rod) with a total diameter of 1 mm. Herein, the "precursor" is a structure prior to final formation of the superconductor wire by the heat treatment.

(Example **2**)

Referring to **FIG. 2**, a Nb rod with an outer diameter of 22 mm was inserted into a Cu pipe with an outer diameter of 30 mm and an inner diameter of 22.2 mm. Thereafter, the Cu pipe accommodating the Nb rod was processed by the area reduction process to have a hexagonal cross-section in which a spacing between opposite sides is 1 mm, thereby manufactured Nb monofilaments.

Next, a rod of Sn-alloy material containing Ti of 2% by mass (Sn-2mass%Ti) and having an outer diameter of 27 mm was inserted into a Cu pipe with an outer diameter of 30 mm and an inner diameter of 27.2 mm. Thereafter, the Cu pipe accommodating the Sn-alloy material rod was processed by the area reduction process to have a hexagonal cross-section in which a spacing between opposite sides is 1 mm, thereby manufactured Sn monofilaments.

Finally, Sn filaments (367 in number) and Nb filaments (1128 in number) a total number of which is 1495, i.e. the ratio in number of the Nb filaments to the Sn filaments is about 3:1 in Example **2**, are disposed in a Cu pipe with an outer diameter of 50 mm and an inner diameter of 44 mm in a dispersing manner. More concretely, one Sn filament was surrounded by a plurality of Nb filaments such that the Sn filaments are not directly adjacent to each other, namely, the Sn filaments are spaced from each other. A Ta-sheet with a thickness of 0.2 mm was provided between the Cu pipe and the filaments as a diffusion barrier layer for preventing Sn from diffusing into Cu surrounding a periphery of Sn, so as to suppress the deterioration in stable superconducting characteristics. The Ta-sheet was wound around the filaments in 5 turns, and inserted into the Cu pipe, to form a multicore composite (precursor). The multicore composite was processed by the area reduction process, to form a multicore wire (precursor wire rod) with a total diameter of 1 mm.

(Example **3**)

Referring to **FIG. 8**, a Nb rod with an outer diameter of 26 mm was inserted into a Cu pipe with an outer diameter of 30 mm and an inner diameter of 26.2 mm. Thereafter, the Cu pipe accommodating the Nb rod was processed by the area reduction process to have a hexagonal cross-section in which a spacing between opposite sides is 2.5 mm, thereby manufactured Nb monofilaments.

Next, a rod of Sn-alloy material containing Ti of 2% by mass (Sn-2mass%Ti) and having an outer diameter of 26 mm was inserted into a Cu pipe with an outer diameter of 30 mm and an inner diameter of 26.2 mm. Thereafter, the Cu pipe accommodating the Sn-alloy material rod was processed by the area reduction process to have a hexagonal cross-section in which a spacing between opposite sides is 2.5 mm, thereby manufactured Sn monofilaments.

Sn filaments (55 in number) and Nb filaments (108 in number) a total number of which is 163, i.e. the ratio in number of the Nb filaments to the Sn filaments is about 2:1 in Example 3, are disposed in a Cu pipe with an outer diameter of 40 mm and an inner diameter of 36 mm in a dispersing manner, to form a sub-element billet (multicore billet). More concretely, one Sn filament was surrounded by a plurality of Nb filaments such that the Sn filaments are not directly adjacent to each other, namely, the Sn filaments are spaced from each other. Thereafter, the sub-element billet was processed by the area reduction process to have a hexagonal cross-section in which a spacing between opposite sides is 3 mm, thereby manufactured sub-element wires.

A plurality of sub-element wires (85 in number) were bundled and inserted into a Cu pipe with an outer diameter of 40 mm and an inner diameter of 33 mm. A Ta-sheet with a thickness of 0.2 mm was provided between the Cu pipe and the sub-element wires as a diffusion barrier layer for preventing Sn from diffusing into Cu surrounding a periphery of Sn, so as to suppress the deterioration in stable superconducting characteristics. The Ta-sheet was wound around the filaments in 5 turns, and inserted into the Cu pipe, to form a multicore composite. The multicore composite was processed by the area reduction process, to form a multicore wire with a diameter of 1 mm.

In Example **3**, the barrier layer is provided between the Cu pipe and the sub-element wires in the multicore wire, so as to prevent Sn of the Sn filament from diffusing into a stabilized Cu in an outermost layer of the multicore wire. It is also possible to achieve the effect of preventing Sn from diffusing out from the barrier layer, by providing the barrier layer inside the Cu pipe of the sub-element wire.

(Example **4**)

In Example **4**, Sn is not coated with Cu. More concretely, a superconductor wire in Example **4** is similar to a precursor **11** for a superconductor wire shown in **FIG. 1**, expect that the Sn single core **16** is composed of Sn-alloy **14** without providing Cu **15**.

ANb rod with an outer diameter of 23 mm was inserted into a Cu pipe with an outer diameter of 30 mm and an inner diameter of 23.2 mm. Thereafter, the Cu pipe accommodating the Nb rod was processed by the area reduction process to have a hexagonal cross-section in which a spacing between opposite sides is 1 mm, thereby manufactured Nb monofilaments (Nb single cores).

Next, a rod of Sn-alloy material containing Ti of 2% by mass (Sn-2mass%Ti) was processed by the area reduction process to have a hexagonal cross-section in which a spacing between opposite sides is 1 mm, thereby manufactured Sn monofilaments (Sn single cores).

Finally, Sn filaments (499 in number) and Nb filaments (499 in number) a total number of which is 1495, i.e. the ratio in number of the Nb filaments to the Sn filaments is about 2:1 in Example 1, are disposed in a Cu pipe with an outer diameter of 50 mm and an inner diameter of 44 mm in a dispersing manner. More concretely, one Sn filament was surrounded by a plurality of Nb filaments (6 in number in Example **1**) such that the Sn filaments are not directly adjacent to each other, namely, the Sn filaments are spaced from each other. A Ta-sheet with a thickness of 0.2 mm was provided between the Cu pipe and the filaments as a diffusion barrier layer for preventing Sn from diffusing into Cu in the Cu pipe surrounding a periphery of Sn, so as to suppress the deterioration in stable superconducting characteristics. The Ta-sheet was wound around the filaments in 5 turns, and inserted into the Cu pipe, to form a multicore composite (precursor). The multicore composite was processed by the area reduction process, to form a multicore wire (precursor wire rod) with a total diameter of 1 mm.

Next, comparative examples will be explained below.

(Comparative example **1**)

Referring to **FIG. 11**, a Nb rod with an outer diameter of 26 mm was inserted into a Cu pipe with an outer diameter of 30 mm and an inner diameter of 26.2 mm. Thereafter, the Cu pipe accommodating the Nb rod was processed by the area reduction process to have a hexagonal cross-section in which a spacing between opposite sides is 2.5 mm, thereby manufactured Nb monofilaments.

Next, a rod of Sn-alloy material containing Ti of 2% by mass (Sn-2mass%Ti) and having an outer diameter of 27 mm was inserted into a Cu pipe with an outer diameter of 30 mm and an inner diameter of 27.2 mm. Thereafter, the Cu pipe accommodating the Sn-alloy material rod was processed by the area reduction process to have a hexagonal cross-section in which a spacing between opposite sides is 6 mm, thereby manufactured Sn monofilaments.

One Sn monofilament with the hexagonal cross-section in which the spacing between the opposite sides is 6 mm is provided at a center portion and Nb filaments (138 in number) each of which has the hexagonal cross-section in which the spacing between the opposite sides is 2.5 mm are provided around a periphery of the Sn filament, in a Cu pipe with an outer diameter of 38 mm and an inner diameter of 34 mm, to form a sub-element billet. Thereafter, the sub-element billet was processed by the area reduction process to have a hexagonal cross-section in which a spacing between opposite sides is 3 mm, thereby manufactured sub-element wires.

Finally, a plurality of sub-element wires (55 in number) were bundled and inserted into a Cu pipe with an outer diameter of 35 mm and an inner diameter of 26 mm. A Ta-sheet with a thickness of 0.2 mm was provided between the Cu pipe and the filaments (sub-element wires) as a diffusion barrier layer. The Ta-sheet was wound around the filaments in 5 turns, and inserted into the Cu pipe, to form a multicore composite. The multicore composite was processed by the area reduction process, to form a multicore wire (precursor wire rod) with a diameter of 1 mm.

(Comparative example **2**)

Referring to **FIG. 12**, a Nb rod with an outer diameter of 26 mm was inserted into a Cu pipe with an outer diameter of 30 mm and an inner diameter of 26.2 mm. Thereafter, the Cu pipe accommodating the Nb rod was processed by the area reduction process to have a hexagonal cross-section in which a spacing between opposite sides is 3 mm, thereby manufactured Nb monofilaments.

A plurality of Nb filaments (85 in number) were inserted into a Cu pipe with an outer diameter of 30 mm and an inner diameter of 26.2 mm. Thereafter, the Cu pipe accommodating the Nb filaments was processed by the area reduction process to have a hexagonal cross-section in which a spacing between opposite sides is 2.5 mm, thereby manufactured sub-element wires.

On the other hand, a rod of Sn-alloy material containing Ti of 2% by mass (Sn-2mass%Ti) and having an outer diameter of 24 mm was inserted into a Cu pipe with an outer diameter of 30 mm and an inner diameter of 24.2 mm.

Thereafter, the Cu pipe accommodating the Sn-alloy material rod was processed by the area reduction process to have a hexagonal cross-section in which a spacing between opposite sides is 2.5 mm, thereby manufactured Sn monofilaments.

Finally, the sub-element wires (108 in number) and the Sn filaments (55 in number) a total number of which is 163 were inserted in a Cu pipe with an outer diameter of 46 mm and an inner diameter of 38.5 mm in a dispersing manner. More concretely, one Sn filament was surrounded by a plurality of sub-element wires (6 in number) such that the Sn filaments are not directly adjacent to each other. A Ta-sheet with a thickness of 0.2 mm was provided between the Cu pipe and the filaments as a diffusion barrier layer for preventing Sn from diffusing into Cu in the Cu pipe surrounding a periphery of Sn, so as to suppress the deterioration in stable superconducting characteristics. The Ta-sheet was wound around the filaments in 5 turns, and inserted into the Cu pipe, to form a multicore composite (precursor). The multicore composite was processed by the area reduction process, to form a multicore wire (precursor wire rod) with a total diameter of 1 mm.

Heat treatment (500°C×100 hours+700°C×100 hours) was carried out on a part of $Nb_3Sn$ precursor wire rods manufactured in accordance with Examples **1** to **4** (the present invention) and comparative examples **1** and **2** (prior arts) to provide $Nb_3Sn$ superconductor wires.

The superconducting characteristics of the superconductor wires thus obtained were evaluated as follows. The critical current value (Ic) was measured in liquid helium (absolute temperature 4.2K) in magnetic fields of 12T(tesla), 11T, and 10T, respectively. The critical current density (Jc) was calculated by dividing the measured critical current value (Ic) by a cross-section area (designed value) ofNb filaments of the superconductor wire.

TABLE **1** shows experimental results of the superconductor wires in Examples **1** to **4** and comparative examples **1** and **2**, namely:

(**1**) Filament size of each filament (single core in the state of the precursor);
(**2**) Single core cross-sectional ratio, i.e. a ratio of a cross-sectional area of each Nb filament to a cross-sectional area of each Sn filament;
(**3**) Total cross-section ratio, i.e. a ratio of a total cross-sectional area of Nb filaments to a total cross-sectional area of Sn filaments;
(**4**) Cross-sectional ratio (%) of Nb filament, i.e. a ratio of a total cross-sectional area of Nb filaments to a total cross-sectional area of a precursor wire rod as a whole;
(**5**) Ic, i.e. the measurement result of the critical current value of the $Nb_3Sn$ superconductor wire after the heat treatment; and
(**6**) Filament Jc, i.e. the critical current density of the $Nb_3Sn$ part calculated from the measured Ic and the cross-sectional area of the Nb filament, by approximating that the $Nb_3Sn$ is generated at a region of the Nb filament.

TABLE 1

| | | Size of Filament (precursor single core) (μm) | | Single core cross-sectional ratio (Nb filament/ Sn filament) | Total cross-sectional ratio (Nb filaments/ Sn filaments) | Nb filament Cross-sectional ratio (%) | Ic (A) | | | Filament Jc (A/mm$^2$) | | |
|---|---|---|---|---|---|---|---|---|---|---|---|---|
| | | Nb | Sn | | | | 12T | 11T | 10T | 12T | 11T | 10T |
| Examples | 1 | 15 4 | 15 4 | 1 | 2 | 26 | 610 | 700 | 940 | 2980 | 3440 | 4590 |
| | 2 | 14 1 | 17 3 | 0 66 | 2 04 | 24 7 | 580 | 670 | 900 | 3000 | 3470 | 4620 |
| | 3 | 4 5 | 4 5 | 1 | 1 96 | 22 9 | 560 | 640 | 860 | 3100 | 3580 | 4770 |
| | 4 | 14 9 | 19 1 | 0.59 | 1 2 | 24 2 | 590 | 690 | 910 | 3120 | 3600 | 4800 |
| Comparative Examples | 1 | 4 4 | 36 3 | 0 016 | 2 | 17 6 | 390 | 450 | 600 | 2830 | 3270 | 4250 (*) |
| | 2 | 4 2 | 46 | 0 008 | 1 54 | 19 8 | 440 | 510 | 680 | 2840 | 3280 | 4270 (*) |
| "*" indicates occurrence of "Quench phenomenon" | | | | | | | | | | | | |

As to (**1**) the size of filament, more concretely, a diameter (distance between the opposite sides, i.e. spacing between the opposite sides in Examples) in the cross-section was calculated by 10-points average, and rounded off to one decimal space as a significant digit. This value coincides with the designed value.

In the Examples and the comparative examples, the length of each filament and the length of the precursor are equal to the length of each filament after the heat treatment, so that the ratio of the total cross-sectional area of each material is substantially equal to the volume ratio of each material.

In the comparative examples **1** and **2**, the filament critical current density (Jc) of each filament in the magnetic field of 12T was 2830 A/mm$^2$ and 2840 A/mm$^2$, respectively. On the other hand, in Examples **1** and **2**, the filament Jc of each filament in the magnetic field of 12T was about 3000 A/mm$^2$. In Example **3**, the filament Jc of the filament in the magnetic field of 12T was 3100 A/mm$^2$. Accordingly, it is confirmed that respective superconductor filaments in Examples of the present invention have the filament Jc higher than that of the superconductor filaments manufactured by the conventional methods.

It is assumed that the filament Jc of the filaments in the comparative examples **1** and **2** was deteriorated due to the disorder in arrangement of the Nb single cores at the time of the drawing process and the heat treatment for providing the superconducting characteristics. On the other hand, it is assumed that the filament Jc of the filaments according to the invention was kept to be high, since the disorder in arrangement of the Nb single cores at the time of the drawing process or the heat treatment for providing the superconducting characteristics was reduced.

As a result of having observed the cross-section of the filament in Example **1** after the heat treatment, it is confirmed that the size of the $Nb_3Sn$ filament is about 16 $\mu$m. On the other hand, as shown in **FIG. 10**, voids (gaps) were partially observed at regions where the Sn single cores were provided. However, the size of the voids and the size of the Sn single core were substantially equal to or less than the size of the Nb single core. Since the filament was manufactured by incorporating the Sn single cores each of which has the same size as the size of the Nb single core, the size of the void generated at the trace of the Sn single core was naturally equal to or less than the size of the Nb single core. Accordingly, even though the electromagnetic force is applied to the $Nb_3Sn$ filament in the present invention, the $Nb_3Sn$ filament electromagnetic force by this is small.

In Example **3**, the filament Jc is higher than those in Examples **1** and **2**. It is assumed that the size of the single core is reduced to 4.5 $\mu$m in accordance with the increase in number of the single cores, so that the diffusion of Sn into the Nb single cores is enhanced, thereby accelerating the generation of $Nb_3Sn$.

Further, in Example **3**, the cross-section after the heat treatment was observed and the size of the $Nb_3Sn$ filament is about 5 $\mu$m. This size of the $Nb_3Sn$ filament is substantially equal to the size of the $Nb_3Sn$ wire manufactured by the conventional bronze method. The size of the Sn core (single core) is naturally about 5 $\mu$m, since the size of the Sn single core was the same as the size of the Nb single core for forming the multicore wire. In Example **3**, the manufacturing process number was increased since the step for forming the multicore structure was conducted twice. However, the size of the $Nb_3Sn$ filament was substantially equal to the size of the $Nb_3Sn$ filament manufactured by the conventional bronze method, and the size of the Sn core was substantially equal to the $Nb_3Sn$. Therefore, it is possible to prevent the Nb single core from moving due to the disorder in arrangement of the Nb single core or the generation of the voids during the drawing process or the heat treatment.

In the case that the magnetic field was reduced to 11T and 10T, the filament Jc of each wire was increased. In a normal critical current measurement, the voltage was slowly generated at a current of around Ic when the current was increased.

As to the wires in Examples **1** to **4**, the voltage was slowly generated at a current of around Ic when the current was increased in any magnetic fields of 12T, 11T and 10T. Therefore, the Ic value could be measured based on generation of a predetermined voltage.

As described above, in Examples **1** to **4**, an effect of increasing the filament Jc was obtained. Further, since the ratio in cross-sectional area of the superconductor wire to the total wire was increased, the critical current (Ic) was further increased.

In the comparative examples **1** and **2**, the voltage was slowly generated at a current of around Ic when the current was increased in the magnetic fields of 12T and 11T. Therefore, the Ic value could be measured based on generation of a predetermined voltage. However, in the magnetic field of 10T, the voltage was suddenly generated (so-called "quench phenomenon" shown as * in TABLE **1**) at the current value of 4250 A/mm$^2$ and 4270 A/mm$^2$, respectively. Therefore, the Ic value could not be defined by the predetermined voltage.

In the superconductor wire manufactured by the conventional method, the disorder in arrangement of the Nb single cores at the time of drawing process or the heat treatment was large. Further, the voids larger than the $Nb_3Sn$ filament were generated at the traces of the Sn single cores due to the heat treatment. It is assumed that the $Nb_3Sn$ filaments were shifted by application of the electromagnetic force at the time of feeding the current in the magnetic field.

According to the superconductor wire of the present invention, the size of the Sn single core is substantially equal to the Nb**3**Sn filament, the disorder in arrangement of the Nb single cores at the time of drawing process or the heat treatment did not occur. Further, the voids larger than the $Nb_3Sn$ filament were not generated at the traces of the Sn single cores due to the heat treatment. It is assumed that the $Nb_3Sn$ filaments was prevented from shifting, even though the electromagnetic force was applied thereto at the time of feeding the current in the magnetic field. Therefore, the quench phenomenon did not occur.

**Claims**

1. A precursor for a $Nb_3Sn$ superconductor wire to be manufactured by the internal Sn diffusion method, comprising:

a Cu tube comprising a barrier layer at an inner surface thereof, the barrier layer comprising a metal selected from the group consisting of Ta, Ta-alloy, Nb and Nb-alloy,
a plurality of Sn single cores disposed in the Cu tube, each of the Sn single cores comprising Sn or Sn-alloy; and
a plurality of Nb single cores disposed in the Cu tube, each of the Nb single cores comprising Nb or Nb-alloy,

wherein the Sn single cores and the Nb single cores are arranged in the Cu tube such that the Sn single cores are not adjacent to each other.

2. The precursor for a $Nb_3Sn$ superconductor wire according to claim **1**, wherein each of the Sn single cores further comprises a Cu layer coating the Sn or the Sn-alloy.

3. The precursor for a $Nb_3Sn$ superconductor wire according to claim **1** or **2**, wherein each of the Nb single cores further comprises a Cu layer coating the Nb or the Nb-alloy.

4. The precursor for a $Nb_3Sn$ superconductor wire according to any one of claims **1** to **3**, wherein each of the Sn single cores are separated from each other.

5. The precursor for a $Nb_3Sn$ superconductor wire according to any one of claims **1** to **4**, wherein the Nb single cores are disposed to surround each of the Sn single cores.

6. The precursor for a $Nb_3Sn$ superconductor wire according to any one of claims **1** to **5**, further comprising a plurality of Cu single cores disposed in the Cu tube.

7. The precursor for a $Nb_3Sn$ superconductor wire according to any one of claims **1** to **6**, wherein a diameter of each of the Sn single core and a diameter of each of the Nb single core in a cross-section of the Cu tube accommodating the Sn single cores and the Nb single cores after drawing process are 30 $\mu m$ or less, respectively.

8. The precursor for a $Nb_3Sn$ superconductor wire according to any one of claims **1** to 7, wherein a ratio of a cross-sectional area of each of the Nb single cores to a cross-sectional area of each of the Sn single cores is within a range of 0.3 to 2.2.

9. The precursor for a $Nb_3Sn$ superconductor wire according to any one of claims **1** to **8**, wherein a ratio of total cross-sectional area of the Nb single cores to a total cross-sectional area of the Sn single cores is within a range of 1.2 to 2.2.

10. A $Nb_3Sn$ superconductor wire manufactured by heat treating the precursor according to any one of claims **1** to **9**.

11. A method for manufacturing a $Nb_3Sn$ superconductor wire, comprising:

conducting area reduction on a Cu pipe to which a Nb rod or a Nb-alloy rod is inserted, thereby providing Nb single cores;
conducting area reduction on a Sn rod or a Sn-alloy rod, thereby providing Sn single cores;
forming a barrier layer comprising a metal selected from the group consisting of Ta, Ta-alloy, Nb and Nb-alloy at an inner surface of a Cu tube;
disposing the Nb single cores and the Sn single cores in the Cu tube, such that the Sn single cores are not adjacent to each other, thereby providing a precursor;
drawing the precursor, thereby providing a precursor wire; and
heat treating the precursor wire.

12. The method according to claim **11**, wherein the step of providing the precursor further comprises:

providing a multicore billet from the Cu tube accommodating the Nb single cores an the Sn single cores such that the Sn single cores are not adjacent to each other;

conducting area reduction on the multicore billet, thereby providing sub-element wires; and

bundling and inserting the sub-element wires into another Cu tube, thereby forming the precursor.

13. The method according to claim **12**, wherein the barrier layer is formed at an inner surface of another Cu tube in place of the Cu tube.

14. The method according to any one of claims **11** to **13**, wherein the Sn rod or the Sn-alloy rod is inserted into another Cu pipe before conducting the area reduction on the Sn rod or the Sn-alloy rod.

## FIG.1

19 Nb SINGLE CORE
11 PRECURSOR
17 Nb OR Nb-ALLOY   18 Cu
14 Sn-ALLOY   15 Cu
16 Sn SINGLE CORE
19
16
13 BARRIER LAYER
12 CU TUBE

## FIG.2

19 Nb SINGLE CORE
21 PRECURSOR
17 Nb OR Nb-ALLOY   18 Cu
14 Sn-ALLOY   15 Cu
16 Sn SINGLE CORE
19
16
13 BARRIER LAYER
12 CU TUBE

## FIG.3

19 Nb SINGLE CORE

31 PRECURSOR

17 Nb OR
Nb-ALLOY          18 Cu

14 Sn-ALLOY     15 Cu

16 Sn SINGLE
CORE

19

16

13 BARRIER LAYER

12 CU TUBE

## FIG.4

19 Nb SINGLE CORE

41 PRECURSOR

17 Nb OR
Nb-ALLOY          18 Cu

14 Sn-ALLOY     15 Cu

16 Sn SINGLE
CORE

19

16

13 BARRIER LAYER

12 CU TUBE

## FIG.5

19 Nb SINGLE CORE

17 Nb OR Nb-ALLOY    18 Cu

51 PRECURSOR

14 Sn-ALLOY
16
15 Cu

42 Cu SINGLE CORE

13 BARRIER LAYER

19

42

12 CU TUBE

16 Sn SINGLE CORE

## FIG.6

19 Nb SINGLE CORE

17 Nb OR Nb-ALLOY    18 Cu

61 PRECURSOR

14 Sn-ALLOY
16
15 Cu

42 Cu SINGLE CORE

13 BARRIER LAYER

19

42

12 CU TUBE

16 Sn SINGLE CORE

## FIG.7

19 Nb SINGLE CORE

17 Nb OR Nb-ALLOY  18 Cu

71 PRECURSOR

16 { 14 Sn-ALLOY / 15 Cu

42 Cu SINGLE CORE

19

42

16 Sn SINGLE CORE

12 CU TUBE

13 BARRIER LAYER

## FIG.8

19 Nb SINGLE CORE

17 Nb OR Nb-ALLOY  18 Cu

83 MULTICORE BILLET

81 PRECURSOR

14 Sn-ALLOY  15 Cu

16 Sn SINGLE CORE

19

16

82 Cu TUBE

84 SUB-ELEMENT WIRE

86

85 Cu TUBE

## FIG.9

17 Nb OR Nb-ALLOY — 18 Cu

19 Nb SINGLE CORE

14 Sn-ALLOY   15 Cu

16 Sn SINGLE CORE

94

91

19   16   92   93

95   96

## FIG.10

## FIG.11

## FIG.12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010242379 A

- JP 2006004684 A

**Non-patent literature cited in the description**

- **J. A. PARRELL et al.** Highfield Nb3Sn conductor development at Oxford Superconducting Technology. *IEEE Trans. Appl. Supercond.,* 2003, vol. 13 (2), 3470-3473
- Chronological Scientific Tables. National Astronomical Observatory, Maruzen

- **YOSHIO KUBO et al.** Analysis of bridging generating mechanism of Nb3Sn filament by the internal diffusion method. *Cryogenics Asian,* 1996, vol. 31 (6), 306-313